# EUROPÄISCHE PATENTANMELDUNG

(11) **EP 4 050 797 A1**
(43) Veröffentlichungstag der Anmeldung: **31.08.2022**
(21) Anmeldenummer: 22152235.2
(22) Anmeldetag: 19.01.2022
(51) Int. Cl.: H03K 3/86, H03K 5/06

(54) **PULSERZEUGUNGSVORRICHTUNG**

(30) Priorität: 25.02.2021 DE 102021104574
(71) Anmelder: SICK AG, 79183 Waldkirch (DE)
(72) Erfinder: Boris, Baldischweiler, 79194 Gundelfingen (DE)
(74) Vertreter: Manitz Finsterwald Patent- und Rechtsanwaltspartnerschaft mbB

(57) **Zusammenfassung**

Die vorliegende Erfindung betrifft eine Pulserzeugungsvorrichtung (10), ausgebildet zur Erzeugung von elektrischen Pulsen (26: P) mit Pulsdauern im Bereich von Nanosekunden, bevorzugt mit Spannungen von maximal 60V und/oder Strömen von maximal 20A, mit einer Signalquelle (12), welche ein Eingangssignal bereitstellt, einem mit der Signalquelle elektrisch gekoppelten Verzögerungsglied (18), welches ein an das Verzögerungsglied angelegtes Signal beim Durchlaufen des Verzögerungsglieds um eine vorbestimmte Zeitdauer verzögert, ein oder mehreren Reflexionsmitteln (24, 14), welche das Verzögerungsglied durchlaufende Signale reflektieren, und einem Signalausgang (26) zur Ausgabe der elektrischen Pulse (p), welcher elektrisch mit dem Verzögerungsglied verbunden ist. Die Pulserzeugungsvorrichtung zeichnet sich dadurch aus, dass das Verzögerungsglied mehrere Teil-Verzögerungsglieder (T1, T2, T3, T4) und die Pulserzeugungsvorrichtung einen oder mehrere Diodenschalter (20: D1, D2, D3) aufweisen, wobei jeder Diodenschalter mit zumindest einem Teil-Verzögerungsglied elektrisch verbunden ist, wobei jeder Diodenschalter (20: D1, D2, D3) eine Diode und eine der Diode zugeordnete Steuer-Spannungsquelle (22) umfasst, wobei durch Veränderung der Spannung der Steuer-Spannungsquelle (22) das jeweilige Teil-Verzögerungsglied wahlweise mit zumindest einem der Reflexionsmittel (24, 14) elektrisch verbindbar ist.

## Beschreibung

Die vorliegende Erfindung betrifft eine Pulserzeugungsvorrichtung, welche zur Erzeugung von elektrischen Pulsen mit Pulsdauern im Bereich von Nanosekunden ausgebildet ist. Die elektrischen Pulse weisen bevorzugt Spannungen von maximal 60 V und/oder Ströme von maximal 20 A auf. Die Pulserzeugungsvorrichtung umfasst eine Signalquelle, welche ein Eingangssignal bereitstellt. Weiterhin umfasst die Pulserzeugungsvorrichtung ein mit der Signalquelle elektrisch gekoppeltes Verzögerungsglied, welches ein an das Verzögerungsglied angelegtes Signal beim Durchlaufen des Verzögerungsglieds um eine vorbestimmte Zeitdauer verzögert. Zudem sind ein oder mehrere Reflexionsmittel vorgesehen, welche das Verzögerungsglied durchlaufende Signal reflektieren. Die Pulserzeugungsvorrichtung umfasst schließlich einen Signalausgang zur Ausgabe der elektrischen Pulse, wobei der Signalausgang elektrisch mit dem Verzögerungsglied verbunden ist.

Pulserzeugungsvorrichtungen werden in verschiedenen Bereichen eingesetzt, um wiederholt sehr kurze Pulse zu erzeugen. Kurze Pulse können beispielsweise in Laserscannern benötigt werden, um aus den kurzen elektrischen Pulsen kurze optische Pulse zu erzeugen, mit welchen die Umgebung abgetastet werden kann.

Hierbei kann es notwendig sein, Pulse mit verschiedenen zeitlichen Längen zu erzeugen. Herkömmlicherweise ist dabei oft die Umrüstung der Pulserzeugungsvorrichtung nötig, was einen großen Aufwand erzeugt.

Es ist daher die der Erfindung zugrundeliegende Aufgabe, eine Pulserzeugungsvorrichtung anzugeben, welche es auf einfache Weise gestattet, Pulse verschiedener zeitlicher Länge zu erzeugen.

Diese Aufgabe wird durch eine Pulserzeugungsvorrichtung gemäß Anspruch 1 gelöst.

Die erfindungsgemäße Pulserzeugungsvorrichtung zeichnet sich dadurch aus, dass das Verzögerungsglied mehrere Teil-Verzögerungsglieder und die Pulserzeugungsvorrichtung einen oder mehrere Diodenschalter aufweisen, wobei jeder Diodenschalter mit zumindest einem Teil-Verzögerungsglied, bevorzugt direkt, elektrisch verbunden ist. Erfindungsgemäß umfasst jeder Diodenschalter eine Diode und eine der Diode zugeordnete Steuer-Spannungsquelle, wobei durch Veränderung der Spannung der Steuer-Spannungsquelle das jeweilige Teil-Verzögerungsglied wahlweise mit zumindest einem der Reflexionsmittel elektrisch verbindbar ist.

Anders ausgedrückt können durch die Diodenschalter verschiedene Teil-Verzögerungsglieder oder Kombinationen der Teil-Verzögerungsglieder bei der Erzeugung der Pulse verwendet werden. Die Länge der zeitlichen Verzögerung eines Signals in den Verzögerungsgliedern wirkt sich dabei auf die Länge der erzeugten Pulse aus, wie später noch näher erläutert wird. Durch die Möglichkeit, verschiedene Teil-Verzögerungsglieder oder verschiedene Kombinationen von Teil-Verzögerungsgliedern zu verwenden, kann die Verzögerungsdauer im Verzögerungsglied und damit die Dauer der Pulse eingestellt werden.

Zudem ist von Vorteil, dass durch die Verwendung von Diodenschaltern die Kapazität der Schalter (d.h. der im Schalter verwendeten Diode) im Sperrfall gering ist. Dadurch wird der Anteil von hohen Frequenzen des Pulses vermindert, der über die Kapazität z.B. nach Masse abfließt. Durch die kleinen Kapazitäten wird also insbesondere bei Pulsen im Bereich von Nanosekunden eine stabile Signalform der Pulse gewährleistet.

Bei der Pulserzeugungsvorrichtung kann beispielsweise eine Reihenschaltung der Signalquelle, des Verzögerungsglieds (d.h. der jeweils gerade durch die Diodenschalter zugeschalteten Teil-Verzögerungsglieder) und des Reflexionsmittels vorgesehen sein. Beim Aktivieren der Signalquelle wird an einem Anschluss der Signalquelle zunächst das Eingangssignal erzeugt. Das Eingangssignal kann eine Signalform ähnlich einer Sprungfunktion aufweisen, d.h. einen möglichst steilen Anstieg umfassen, wobei das Eingangssignal nach dem Anstieg für zumindest eine vorbestimmte Zeitdauer (z.B. zumindest 1 ms) konstant bleibt. Das Eingangssignal kann in diesem Beispiel dann an das Verzögerungsglied übertragen werden, wobei das Eingangssignal das Verzögerungsglied durchläuft. Beim Durchlaufen des Verzögerungsglieds wird zumindest ein Teil-Verzögerungsglied durchlaufen.

Insbesondere nach dem Durchlaufen des Verzögerungsglieds wird das Eingangssignal von dem Reflexionsmittel reflektiert, insbesondere mit invertierter Phase, und läuft durch das Verzögerungsglied zurück, wobei dann am Eingang des Verzögerungsglieds (d.h. an demjenigen Anschluss des Verzögerungsglieds, der, insbesondere über ein Anpasselement, mit der Signalquelle gekoppelt ist) das Eingangssignal durch das reflektierte Signal aufgrund der invertierten Phasenlage ausgelöscht werden kann. Der Eingang des Verzögerungsglieds kann zugleich der Signalausgang sein. Am Eingang des Verzögerungsglieds bzw. am Signalausgang liegt also nur sehr kurze Zeit ein Signal an, und zwar insbesondere so lange, bis das Verzögerungsglied zwei Mal durchlaufen wurde und das Eingangssignal durch das reflektierte Signal ausgelöscht wird. Die Zeitdauer, wie lange das Signal vorliegt, kann über die Länge des Verzögerungsglieds bzw. die vorbestimmte Zeitdauer, um welche das Verzögerungsglied ein Signal verzögert (Verzögerungsdauer), eingestellt werden. Auf diese Weise lassen sich Pulse mit Pulsdauern im Bereich von Nanosekunden (z.B. 0,05 bis 20 ns, bevorzugt 0,1 bis 10 ns, besonders bevorzugt 0,5 bis 3 ns) auf einfache Weise erzeugen. Durch die verschiedenen Teil-Verzögerungsglieder kann mittels der Diodenschalter zwischen verschiedenen Verzögerungsdauern umgeschaltet werden, welche dann wieder in verschiedenen Pulsdauern resultieren.

Die Dioden der Diodenschalter können durch die jeweilige Steuer-Spannungsquelle leitend oder nicht-leitend geschaltet werden. Die Dioden wirken dementsprechend wie ein Schalter. Im Vergleich zum Einsatz von Transistoren, welche üblicherweise als elektrische Schalter verwendet werden, können die Dioden eine deutlich geringere elektrische Kapazität aufweisen. Simulationen und Versuche haben gezeigt, dass durch die geringe Kapazität der Dioden eine sehr stabile Signalform der elektrischen Pulse entsteht, wobei insbesondere ein stabiles "Plateau" des Pulses erzeugt wird. Im Vergleich dazu haben die Simulationen gezeigt, dass die Verwendung von Transistoren aufgrund deren höherer Kapazität zu einem zwischenzeitlichen Signaleinbruch im "Plateau" des Pulses und auch zu Schwingungen nach Ende des Pulses führen würde.

Erfindungsgemäß kann am Signalausgang also ein deutlich stabileres Pulssignal mit umschaltbarer zeitlicher Länge erzeugt werden.

Im Folgenden werden noch weitere Aspekte der erfindungsgemäßen Pulserzeugungsvorrichtung detaillierter erläutert.

Die Pulserzeugungsvorrichtung kann eine Steuereinheit aufweisen, welche beispielsweise die Signalquelle und die Diodenschalter ansteuert.

Bevorzugt ist das Reflexionsmittel mittels des Verzögerungsglieds (d.h. mit den jeweils aktiven Teil-Verzögerungsgliedern) mit der Signalquelle elektrisch verbunden. Dies bedeutet, es kann eine Reihenschaltung von Signalquelle (insbesondere umfasst die Signalquelle das Anpasselement), Verzögerungsglied und Reflexionsmittel (beispielsweise in der genannten Reihenfolge) vorliegen. Bei dem nachfolgend auch erwähnten inversen Aufbau der Pulserzeugungsvorrichtung kann das Reflexionsmittel auch zwischen der Signalquelle und dem Verzögerungsglied angeordnet sein oder sogar durch die Signalquelle selbst gebildet werden.

Weiter bevorzugt ist der Signalausgang jeweils auf der dem Reflexionsmittel gegenüberliegenden Seite des Verzögerungsglieds angeordnet. Der Signalausgang und das Reflexionsmittel können mittels des Verzögerungsglieds elektrisch miteinander verbunden sein. Anders ausgedrückt, kann eine Reihenschaltung von Signalausgang, Verzögerungsglied und Reflexionsmittel (beispielsweise in der genannten Reihenfolge) vorliegen.

Die von der Pulserzeugungsvorrichtung ausgegebenen Pulse weisen insbesondere Logikpegel auf. Dies bedeutet, dass die Spannung und/oder der Strom des jeweiligen Pulses mit Logikschaltungen kompatibel ist. Beispielsweise kann eine Kompatibilität mit TTL-Logik, mit CMOS-Logik oder mit Low-Voltage-CMOS-Logik implementiert sein. Auch eine Kompatibilität eines Ausgangssignals (d.h. des Signals am Signalausgang) mit der HCT-Logikfamilie ist möglich. Insbesondere können die ausgegebenen Pulse einen Spannungsbetrag zwischen z.B. 2 und 5 V, bevorzugt bis zu 5 V, besonders bevorzugt bis zu 3,3 V aufweisen. Alternativ sind auch Kleinspannungen möglich, insbesondere Spannungen mit einem Betrag bis 48 V oder 60 V und/oder Ausgangsströme von weniger als 20 A, bevorzugt von weniger als 10 A oder 5 A, weiter bevorzugt von weniger als 500 mA, besonders bevorzugt von weniger als 20 mA.

Wie erwähnt, kann eine Reihenschaltung von Signalquelle, Verzögerungsglied und Reflexionsmittel verwendet werden. Der Signalausgang kann dabei insbesondere durch die elektrische Verbindung von Signalquelle und Verzögerungsglied gebildet sein.

Das Reflexionsmittel kann beispielsweise durch ein geschlossenes Ende einer elektrischen Leitung gebildet sein, d.h. das Reflexionsmittel umfasst eine elektrische Verbindung auf ein Bezugspotential, insbesondere auf Masse. Hierzu kann ein Anschluss des Verzögerungsglieds, welcher dem mit der Signalquelle verbundenen Eingang des Verzögerungsglieds gegenüberliegt, zum Beispiel direkt mit Masse verbunden sein. Alternativ kann das Reflexionsmittel auch ein offenes Ende einer elektrischen Leitung umfassen, wobei ein Ausgang des Verzögerungsglieds insbesondere unbeschaltet bleiben kann oder mittels eines Widerstands von mehreren Megaohm, z.B. mit Masse oder einem anderen Potenzial z.B. einer Spannungsquelle verbunden wird.

Die Teil-Verzögerungsglieder umfassen insbesondere jeweils eine elektrische Leitung mit einer vorbestimmten Länge, wobei die Verzögerungsdauer die Zeitdauer ist, die ein elektrisches Signal zum Durchlaufen der Leitung benötigt. Als Eingang des Verzögerungsglieds (oder des jeweiligen Teil-Verzögerungsglieds) wird dabei dasjenige Ende der Leitung angesehen, das mit der Signalquelle elektrisch verbunden ist. Als Ausgang des Verzögerungsglieds kann dementsprechend das dem Eingang gegenüberliegende Ende des Verzögerungsglieds angesehen werden.

Bei der elektrischen Leitung kann es sich beispielsweise um eine Koaxial-Leitung oder um eine Mikrostreifen-Leitung auf einer Leiterplatte handeln.

Bevorzugt ist die Pulserzeugungsvorrichtung vollständig auf einer einzelnen Leiterplatte (Printed Circuit Board - PCB) angeordnet. Hierdurch kann eine kompakte Ausbildung der Pulserzeugungsvorrichtung unterstützt werden.

Mit der erfindungsgemäßen Pulserzeugungsvorrichtung können bevorzugt auch Einzelpulse erzeugt werden. Dies bedeutet, eine Zeitdauer (Pause) zwischen einzelnen Pulsen ist länger als die Pulsdauer. Bevorzugt ist die Zeitdauer zwischen einzelnen Pulsen zehn Mal oder einhundert Mal länger als die Pulsdauer.

Es versteht sich, dass in diesem Kontext unter einer Verbindung bzw. Kopplung und/oder einem Signal jeweils eine elektrische Verbindung bzw. Kopplung und/oder ein elektrisches Signal gemeint ist, sofern nicht explizit anders angegeben.

Vorteilhafte Weiterbildungen der Erfindung sind in der Beschreibung, den Figuren und den Unteransprüchen angegeben.

Gemäß einer ersten vorteilhaften Ausführungsform sind die Diode und die Steuer-Spannungsquelle zumindest eines Diodenschalters in Reihe geschaltet. Durch die Reihenschaltung kann die Steuer-Spannungsquelle das Potential an der Anode oder der Kathode der Diode erhöhen oder erniedrigen, um die Diode leitend oder nicht-leitend zu schalten.

Es können auch jeweils die Diode und die Steuer-Spannungsquelle mehrerer oder aller Diodenschalter in Reihe geschaltet sein. Es versteht sich, wenn im Folgenden von "zumindest einem Diodenschalter" oder "zumindest einer Steuer-Spannungsquelle" gesprochen wird, dass immer auch gemeint ist, dass die Offenbarung für mehrere oder alle gilt.

Gemäß einer weiteren vorteilhaften Ausführungsform ist zumindest ein Diodenschalter ausgebildet, durch eine elektrische Verbindung eines Teil-Verzögerungsglieds mit einem der Reflexionsmittel, ein Durchlaufen des Eingangssignals durch dasjenige Teil-Verzögerungsglied zu bewirken.

Leitend geschaltet kann ein Diodenschalter bewirken, dass ein jeweils mit dem Diodenschalter gekoppeltes Teil-Verzögerungsglied vom Eingangssignal durchlaufen wird. Das Durchlaufen kann zumindest in eine Richtung erfolgen. Üblicherweise durchläuft das Eingangssignal das Teil-Verzögerungsglied aber zuerst in eine Richtung, wird dann an dem Reflexionsmittel reflektiert und durchläuft das Teil-Verzögerungsglied nach der Reflexion dann in die andere Richtung.

Gemäß einer weiteren vorteilhaften Ausführungsform verzögern die Teil-Verzögerungsglieder ein Signal beim Durchlaufen, um dieselbe vorbestimmte Zeitdauer. Alternativ oder zusätzlich verzögern zumindest zwei der Teil-Verzögerungsglieder ein Signal beim Durchlaufen um unterschiedliche vorbestimmte Zeitdauern. Eine gleiche Zeitdauer der Verzögerung kann beispielsweise bei einer Reihenschaltung der Verzögerungsglieder gewählt werden, wohingegen unterschiedliche Zeitdauern beim Durchlaufen bei einer Parallelschaltung der Teil-Verzögerungsglieder verwendet werden können. Der Unterschied zwischen zwei vorbestimmten Zeitdauern kann zum Beispiel zumindest 10% oder 50% der Zeitdauer betragen.

Durch die Diodenschalter ist es bevorzugt möglich, unterschiedliche Kombinationen von Teil-Verzögerungsgliedern elektrisch mit zumindest einem der Reflexionsmittel zu verbinden, um so ein Durchlaufen des Eingangssignals durch die jeweiligen Teil-Verzögerungsglieder zu bewirken. Auf diese Weise können unterschiedliche Verzögerungen des Eingangssignals und damit unterschiedliche Pulsdauern ermöglicht werden. Beispielsweise kann die Pulsdauer etwa der Zeitdauer entsprechen, die für das zweimalige Durchlaufen der jeweils durchlaufenen Teil-Verzögerungsglieder notwendig ist.

Gemäß einer weiteren Ausführungsform ist zumindest ein Diodenschalter ausgebildet, im leitenden Zustand von dem Eingangssignal durchlaufen zu werden, wobei das Eingangssignal bevorzugt durch die Diode und/oder auch durch die Steuer-Spannungsquelle desjenigen Diodenschalters durchläuft. Die Diode und die Steuer-Spannungsquelle eines jeweiligen Diodenschalters können also direkt in den Strompfad des Eingangssignals geschaltet sein und sind insbesondere nicht durch Kondensatoren oder Spulen entkoppelt. Zusätzliche Kondensatoren oder Spulen könnten nämlich zu einer Verschlechterung der Pulsform des erzeugten Pulses führen.

Bevorzugt ist die Signalquelle eine Spannungsquelle. Alternativ kann die Signalquelle auch eine Stromquelle sein. Eine Spannungsquelle liefert im Betrieb eine vorbestimmte Spannung, wohingegen eine Stromquelle im Betrieb einen vorbestimmten Strom einträgt. Je nach Anwendungsfall kann eine Spannungsquelle oder eine Stromquelle benötigt werden. Hierbei ist zu beachten, dass bei einer Reflexion am offenen Ende eine Stromwelle mit negativem Vorzeichen (d.h. mit invertierter Phase) und eine Spannungswelle mit positivem Vorzeichen (d.h. mit gleicher Phase) zurückgeworfen wird. In entsprechender Weise wird bei einer Reflexion am geschlossenen Ende (Reflexion am Kurzschluss) eine Stromwelle mit positivem Vorzeichen und eine Spannungswelle mit negativem Vorzeichen zurückgeworfen. Je nach Anwendungsfall muss also das Reflexionsmittel entsprechend gewählt werden. Beispielsweise kann bei der Verwendung einer Spannungsquelle als Signalquelle ein Kurzschluss als Reflexionsmittel verwendet werden, um nach dem doppelten Durchlaufen des Verzögerungsglieds ein Auslöschen des Eingangssignals am Eingang des Verzögerungsglieds zu bewirken. Auch könnte stattdessen eine Stromquelle verwendet werden. Abhängig von der Wahl des Reflexionsmittels (offenes oder geschlossenes Ende) kann entweder ein Spannungs- oder ein Strompuls erzeugt werden.

Dementsprechend kann das Reflexionsmittel einen Kurzschluss oder ein offenes Leitungsende umfassen. Bei dem Kurzschluss wird bevorzugt eine niederohmige Verbindung mit Masse hergestellt. Beim offenen Leitungsende besteht gar keine oder eine sehr hochohmige (z.B. >1 kΩ, >10 kΩ, >100 kΩ oder größer 1 MΩ) Verbindung mit Masse.

Insbesondere ist die Signalquelle, bevorzugt ausschließlich, kapazitiv mit dem Verzögerungsglied verbunden. Dies bedeutet, ein Kondensator kann zwischen die Signalquelle und das Verzögerungsglied geschaltet sein. Es kann also eine Reihenschaltung von Signalquelle, Kondensator und Verzögerungsglied vorliegen (in dieser Reihenfolge). Die Signalquelle kann auf diese Weise kapazitiv entkoppelt sein. Hierdurch kann eine Verringerung der Belastung der Signalquelle erreicht werden, da die Signalquelle keinen Dauerstrom durch das Verzögerungsglied treiben muss. Parallel zu dem Kondensator zwischen Signalquelle und Verzögerungsglied kann auch ein hochohmiger Widerstand (z.B. >10 kΩ oder >100 kΩ) geschaltet sein. Durch den parallel geschalteten Widerstand kann sich das Verzögerungsglied über längere Zeitperioden auf dem gleichen Pegel/Potential befinden, wie die Signalquelle.

Gemäß einer weiteren vorteilhaften Ausführungsform ist die Diode zumindest eines Diodenschalters eine pn-Diode, beispielsweise eine Schottky-Diode. Es können auch wiederum mehrere oder alle der Dioden pn-Dioden, insbesondere Schottky-Dioden sein. Durch die Verwendung von Schottky-Dioden werden die Verlustspannungen an der Diode minimiert. In diesem Zusammenhang ist zu erwähnen, dass die Diodenschalter auch niederfrequente Signalanteile passieren lassen bzw. sperren sollen. Durch die geringe Verlustspannung werden die niederfrequenten Signalanteile nur geringfügig verändert.

Gemäß einer weiteren vorteilhaften Ausführungsform weist die Diode zumindest eines Diodenschalters eine Kapazität von weniger als 400 fF, bevorzugt von weniger als 300 fF oder 200 fF auf. Durch die geringe Kapazität wird der bereits erläuterte Vorteil erzielt, dass das elektrische Signal der Pulse wenige Schwingungen und insbesondere keine zwischenzeitlichen Einbrüche umfasst. Zudem wird ein sehr schnelles Schalten ermöglicht. Bei der genannten Kapazität kann es sich insbesondere um die "Zero Bias Junction" Kapazität handeln, also die Kapazität der Sperrschicht der Diode ohne Stromfluss.

Bevorzugt kann zu der Steuer-Spannungsquelle zumindest eines Diodenschalters eine Stützkapazität parallelgeschaltet sein. Durch die Parallelschaltung wird vorteilhafterweise bei Signalquellen mit höherem Innenwiderstand der Signalverlauf des Pulses stabilisiert, da die Stützkapazität für das Eingangssignal eine Verbindung zum Reflexionsmittel herstellen kann. Die Stützkapazität kann beispielsweise eine Kapazität von zumindest 50 nF oder zumindest 100 nF aufweisen.

Gemäß einer weiteren vorteilhaften Ausführungsform ist ein Anpasselement vorhanden, welches eine Anpassung des Widerstands der Signalquelle an den Wellenwiderstand des Verzögerungsglieds (d.h. an die jeweils gerade elektrisch verbundenen Teil-Verzögerungsglieder) bewirkt. Das Anpasselement kann beispielsweise einen elektrischen Widerstand umfassen (z.B. mit 50 Ω), welcher bevorzugt zwischen die Signalquelle und das Verzögerungsglied geschaltet ist. Der elektrische Widerstand des Anpasselements kann gleich dem Wellenwiderstand des Verzögerungsglieds sein.

Es kann also eine Reihenschaltung von Signalquelle, Anpasselement und Verzögerungsglied vorliegen. Die Verwendung eines Widerstands mit 50 Ω kann die Signalquelle an einen Wellenwiderstand von ebenfalls 50 Ω des Verzögerungsglieds anpassen. Das Anpasselement kann auch den Innenwiderstand der Signalquelle umfassen. Dementsprechend kann ein zusätzlich zwischen Signalquelle und Verzögerungsglied vorgesehener Widerstand kleiner als der Wellenwiderstand des Verzögerungsglieds ausfallen (z.B. 40 Ω), sofern die Signalquelle einen Innenwiderstand von 10 Ω aufweist.

Gemäß einer weiteren vorteilhaften Ausführungsform umfasst das Anpasselement eine nicht-leuchtende Diode und/oder eine Leuchtdiode und/oder eine Laserdiode und bevorzugt einen ohmschen Widerstand, wobei die Größe des ohmschen Widerstands kleiner als der Wellenwiderstand oder gleich dem Wellenwiderstand des Verzögerungsglieds ist. Die Diode bzw. die Leuchtdiode bzw. die Laserdiode führt, gegebenenfalls gemeinsam mit dem ohmschen Widerstand, eine Anpassung an den Wellenwiderstand des Verzögerungsglieds durch. Der ohmsche Widerstand kann auch entfallen oder kann durch den ohmschen Widerstand der Diode, der Leuchtdiode oder der Laserdiode gebildet sein. Das Anpasselement kann also beispielsweise den Verbraucher des durch die Vorrichtung erzeugten Pulses umfassen (eine Leuchtdiode oder Laserdiode). Durch die Verwendung einer Leuchtdiode bzw. einer Laserdiode in dem Anpasselement kann direkt in der Pulserzeugungsvorrichtung ein optischer Puls erzeugt werden, der von der Leuchtdiode bzw. der Laserdiode stammt. Bei der Laserdiode kann es sich bevorzugt um einen Oberflächenemitter oder um einen VCSEL (von "Vertical-Cavity Surface-Emitting Laser") handeln. Der von der Laserdiode oder der Leuchtdiode ausgesandte optische (Licht-)Puls kann bevorzugt kürzer sein, als der elektrische Puls. Beispielsweise kann ein optischer Puls mit einer Länge von etwa 100 ps erzeugt werden.

Die Verwendung einer Leuchtdiode oder einer Laserdiode besitzt zudem den technischen Vorteil, dass Bauteile eingespart werden können, da separate Bauteile zur Anpassung an den Wellenwiderstand des Reflexionsmittels überflüssig werden. Der Innenwiderstand der Leuchtdiode oder der Laserdiode kann die eigentliche Anpassung vornehmen, wobei der Innenwiderstand kleiner als üblicherweise erforderlich sein kann, da die Richtungswirkung der Leucht- oder Laserdiode Reflexionen verhindert. Selbiges gilt ebenfalls für eine "normale" Diode als Anpasselement.

Gemäß einer weiteren vorteilhaften Ausführungsform ist der Signalausgang mit einem Pegelwandler gekoppelt, insbesondere mit einem Logikgatter. Durch die Verwendung eines Pegelwandlers kann zuverlässig ein kompatibler Logikpegel ausgegeben werden, was die Weiterverarbeitung des Pulses in einer Logikschaltung erleichtert. Eine an den Signalausgang angeschlossene elektrische Schaltung oder ein dort angeschlossener Pegelwandler sind bevorzugt hochohmig im Vergleich zu dem Wellenwiderstand des Verzögerungsglieds. Insbesondere weist der Pegelwandler oder die angeschlossene elektrische Schaltung einen Eingangswiderstand auf, welcher zumindest zehn oder einhundert Mal größer ist als der Wellenwiderstand des Verzögerungsglieds. Der Pegelwandler kann insbesondere aus der HCT-Logikfamilie stammen. Diese Logikfamilie interpretiert bereits ein Spannungssignal von etwa 40% der Nennspannung als ein positives Signal (bei 5 V Logikpegel wird bereits ein Signal von 2 V als "high" angesehen).

Gemäß einer weiteren vorteilhaften Ausführungsform sind die Signalquelle und die Teil-Verzögerungsglieder in Reihe geschaltet, wobei einer der Diodenschalter jeweils an einer elektrischen Verbindung zwischen zwei Teil-Verzögerungsgliedern angeschlossen ist.

Es kann - rein beispielhaft - eine Reihenschaltung von Signalquelle, Anpasselement, einem ersten, zweiten, dritten und vierten Teil-Verzögerungsglied und einem Reflexionsmittel vorliegen. Das Reflexionsmittel kann in diesem Beispiel als Kurzschluss auf Masse ausgebildet sein. Zwischen dem ersten und zweiten, zwischen dem zweiten und dritten sowie zwischen dem dritten und vierten Teil-Verzögerungsglied ist jeweils ein Diodenschalter angeschlossen, der jeweils ebenfalls mit Masse gekoppelt ist. Bei diesen Diodenschaltern handelt es sich um einen ersten, zweiten und dritten Diodenschalter. Der erste Diodenschalter ist dementsprechend an die Verbindung des ersten und zweiten Teil-Verzögerungsglieds, der zweite Diodenschalter an die Verbindung des zweiten und dritten Teil-Verzögerungsglieds und der dritte Diodenschalter an die Verbindung des dritten und vierten Teil-Verzögerungsglieds angeschlossen. Die Verbindungen mit Masse der Diodenschalter dienen ebenfalls als Reflexionsmittel.

Jeweils die Anode der Dioden der Diodenschalter können mit der Verbindung zwischen zwei Teil-Verzögerungsgliedern gekoppelt sein. Die Kathode ist bevorzugt mit der jeweiligen Steuer-Spannungsquelle des Diodenschalters verbunden.

Im Folgenden wird nun davon ausgegangen, dass die Steuer-Spannungsquelle des zweiten Diodenschalters 0 V einprägt und die Kathode der Diode des zweiten Diodenschalters somit auf Massepotential liegt. Die Steuer-Spannungsquellen des ersten und dritten Diodenschalters prägen hingegen 2,5 V ein, so dass die Kathodendioden des ersten und dritten Diodenschalters auf 2,5 V liegen.

Wird nun von der Signalquelle (in diesem Beispiel einer Spannungsquelle) ein Eingangssignal von 5 V ausgegeben, so durchläuft dieses Spannungssignal als Spannungswelle zunächst das Anpasselement, welches als Widerstand von 50 Ω ausgeführt sein kann. Der Signalausgang wird durch die elektrische Verbindung zwischen dem Anpasselement und dem ersten Teil-Verzögerungsglied gebildet. Die Spannungswelle durchläuft weiterhin das erste Teil-Verzögerungsglied, wodurch sich am Signalausgang aufgrund des Spannungsteilers von Anpasselement und erstem Teil-Verzögerungsglied eine Spannung von 2,5 V einstellt (wenn die Teil-Verzögerungsglieder einen Wellenwiderstand von ebenfalls 50 Ω besitzen). An der Anode der Diode des Diodenschalters liegt somit eine Spannung von 2,5 V an. Diese Spannung entspricht aber genau der Spannung an der Kathode der Diode des ersten Diodenschalters, wodurch die Diode des ersten Diodenschalters sperrt. Das Spannungssignal durchläuft dann das zweite Teil-Verzögerungsglied und liegt dann an der Anode der Diode des zweiten Diodenschalters an. Dort liegt an der Kathode aber 0 V an, so dass die Diode leitend wird und eine Verbindung mit der Steuer-Spannungsquelle und der zu der Steuer-Spannungsquelle parallel geschalteten Stützkapazität herstellt. Die Spannungswelle des Eingangssignals durchläuft die Diode und zumindest die Stützkapazität des zweiten Diodenschalters (da die Stützkapazität aufgrund der hohen Frequenzanteile des Eingangssignals niederimpedant ist und für das Eingangssignal eine Verbindung mit Masse herstellt). Daraufhin wird die Spannungswelle an Masse wie an einem Kurzschluss negativ reflektiert und läuft durch die Stützkapazität, die Diode, das zweite Teil-Verzögerungsglied und das erste Teil-Verzögerungsglied zurück zum Signalausgang, wo sie das bisherige Eingangssignal auslöscht, so dass die Spannung am Signalausgang auf Null absinkt.

Wird davon ausgegangen, dass jedes Teil-Verzögerungsglied eine Verzögerung um 200 ps bewirkt, so werden im vorliegenden Beispiel zwei Teil-Verzögerungsglieder jeweils zwei Mal durchlaufen, so dass sich ein Puls mit einer Länge von 800 ps (0,8 ns) ergibt.

Es versteht sich, dass durch unterschiedliche Ansteuerung der Steuer-Spannungsquellen ausgewählt werden kann, welche Teil-Verzögerungsglieder von dem Eingangssignal durchlaufen werden. Sind beispielsweise alle Steuer-Spannungsquellen aktiviert, z.B. auf 2,5V gestellt, so werden alle Teil-Verzögerungsglieder durchlaufen.

Gemäß einer alternativen Ausführungsform umfasst die Pulserzeugungsvorrichtung mehrere Stränge aus jeweils einer der Dioden, einem der Teil-Verzögerungsglieder und einer der Steuer-Spannungsquellen, wobei die mehreren Stränge zueinander parallelgeschaltet sind. Die Diode und die Steuer-Spannungsquelle eines Strangs bilden jeweils einen Diodenschalter. Zwischen der Diode und der Steuer-Spannungsquelle eines Strangs kann ein jeweiliges Teil-Verzögerungsglied zwischengeschaltet sein. Die mehreren Stränge können an einem Verbindungspunkt miteinander verbunden sein, wobei der Verbindungspunkt der Stränge den Signalausgang bilden. Der Signalausgang kann über einen Auslöseschalter wahlweise mit Masse verbunden werden. Zwischen dem Signalausgang und dem Auslöseschalter kann zudem die vorgenannte Leucht- oder Laserdiode vorgesehen sein.

Die Teil-Verzögerungsglieder der verschiedenen Stränge können jeweils verschieden lange Verzögerungen eines durchlaufenden Signals bewirken. In jedem Strang kann zudem ein ohmscher Widerstand vorhanden sein, welcher als Reflexionsmittel dient. Der Widerstand kann beispielsweise 1 kΩ, 10 kΩ oder größer sein und zwischen das jeweilige Teil-Verzögerungsglied und Masse geschalten sein. Bevorzugt kann der ohmsche Widerstand, welcher das Reflexionsmittel bildet, durch den Innenwiderstand der jeweiligen Steuer-Spannungsquelle eines Strangs gebildet sein oder diesen umfassen.

Die Steuer-Spannungsquelle eines jeweiligen Strangs dient dabei zugleich als Signalquelle. Beispielhaft wird nun von drei Strängen ausgegangen, welcher insgesamte ein erstes, zweites und drittes Teil-Verzögerungsglied umfassen. Die Steuer-Spannungsquelle des ersten Strangs ist in diesem Beispiel als einzige Steuer-Spannungsquelle aktiv.

Durch die aktive Steuer-Spannungsquelle des ersten Strangs wird an dem Signalausgang zunächst eine Spannung angelegt. Die anderen Stränge sind elektrisch durch die Dioden von dem Signalausgang getrennt.

Der Auslöseschalter wird zunächst nicht-leitend geschaltet, so dass insbesondere durch die Leucht- oder Laserdiode kein Strom fließt (die Leitungen zu dem Auslöseschalter wird aber energetisch aufgeladen). Wird der Auslöseschalter nun geschlossen, so beginnt ein Stromfluss, d.h. der Puls beginnt. Durch den Stromfluss stellt sich ein Spannungsteiler zwischen der Leucht- oder Laserdiode und dem Teil-Verzögerungsglied des ersten Strangs ein. Durch die plötzlich erniedrigte Spannung entsteht eine Stromwelle, welche die Diode und das Teil-Verzögerungsglied des ersten Strangs durchläuft, an dem Reflexionsmittel (d.h. an dem Innenwiderstand der Steuer-Spannungsquelle) des ersten Strangs reflektiert wird und zum Signalausgang zurückkehrt, wo der Puls durch die reflektierte Welle strommäßig ausgelöscht wird. Damit endet der Stromfluss durch die Leucht- oder Laserdiode nach sehr kurzer Zeit. Die Leucht- oder Laserdiode hat dabei einen kurzen Lichtpuls abgegeben. Die Zeitdauer des elektrischen Pulses entspricht insbesondere der doppelten Durchlaufdauer durch das jeweils gerade elektrisch mit dem Signalausgang gekoppelte Teil-Verzögerungsglied.

Wie oben ausgeführt, kann zumindest eine der Steuer-Spannungsquellen zugleich auch als Signalquelle und/oder zugleich auch als Reflexionsmittel dienen.

Auch in dieser Ausführungsform kann durch unterschiedliche Ansteuerung der Steuer-Spannungsquellen ausgewählt werden, welches Teil-Verzögerungsglied von dem Eingangssignal (d.h. der Stromwelle) durchlaufen wird. In dieser Ausführungsform ist bevorzugt zu einer Zeit immer nur eine Steuer-Spannungsquelle aktiv.

Weiterer Gegenstand der Erfindung ist ein entfernungsmessendes optoelektronisches System mit einer Pulserzeugungsvorrichtung der hierin beschriebenen Art und mit zumindest einer Laserquelle, welche mit von der Pulserzeugungsvorrichtung erzeugten Pulsen betrieben wird. Die Laserquelle kann insbesondere die oben erwähnte Laserdiode sein. Bei dem entfernungsmessenden System kann es sich beispielsweise um einen Laserscanner handeln, der Lichtpulse in verschiedene Raumrichtungen aussendet. Alternativ kann es sich auch um einen 1D-Taster handeln, welcher die Lichtpulse in nur eine Richtung aussendet, um eine Entfernung zu messen.

Weiterer Gegenstand der Erfindung ist ein Verfahren zur Erzeugung von elektrischen Pulsen mit Pulsdauern im Bereich von Nanosekunden bevorzugt mit Spannungen von maximal 60 V und/oder Strömen von maximal 20 A, bei welchem
- eine Signalquelle ein Eingangssignal erzeugt,
- das Eingangssignal ein Verzögerungsglied, welches ein an das Verzögerungsglied angelegtes Signal beim Durchlaufen des Verzögerungsglieds um eine vorbestimmte Zeitdauer verzögert, durchläuft,
- das Eingangssignal nach dem Durchlaufen zumindest eines Teils des Verzögerungsglieds an ein oder mehreren Reflexionsmitteln reflektiert wird,
- eine Überlagerung des Eingangssignals und des reflektierten Eingangssignals erfolgt, um einen elektrischen Puls zu erzeugen.

Das Verfahren zeichnet sich dadurch aus, dass das Verzögerungsglied mehrere Teil-Verzögerungsglieder und die Pulserzeugungsvorrichtung einen oder mehrere Diodenschalter aufweisen, wobei jeder Diodenschalter mit zumindest einem Teil-Verzögerungsglied elektrisch verbunden ist, wobei jeder Diodenschalter eine Diode und eine der Diode zugeordnete Steuer-Spannungsquelle umfasst, wobei die Spannung zumindest einer der Steuer-Spannungsquellen verändert wird, um ein Teil-Verzögerungsglied mit zumindest einem der Reflexionsmittel elektrisch zu verbinden oder elektrisch von dem Reflexionsmittel zu trennen.

Die Ausführungen zu der erfindungsgemäßen Pulserzeugungsvorrichtung gelten für das erfindungsgemäße Verfahren entsprechend. Dies gilt insbesondere hinsichtlich Vorteilen und bevorzugten Ausführungsformen.

Nachfolgend wird die Erfindung rein beispielhaft unter Bezugnahme auf die Zeichnungen beschrieben. Es zeigen:
- Fig. 1: eine Pulserzeugungsvorrichtung zur Ausgabe eines elektrischen Pulses gemäß einer ersten Ausführungsform;
- Fig. 2: ein Ausgangssignal der Pulserzeugungsvorrichtung von Fig. 1;
- Fig. 3: eine Pulserzeugungsvorrichtung gemäß einer zweiten Ausführungsform; und
- Fig. 4: ein Ausgangssignal der Pulserzeugungsvorrichtung von Fig. 3.

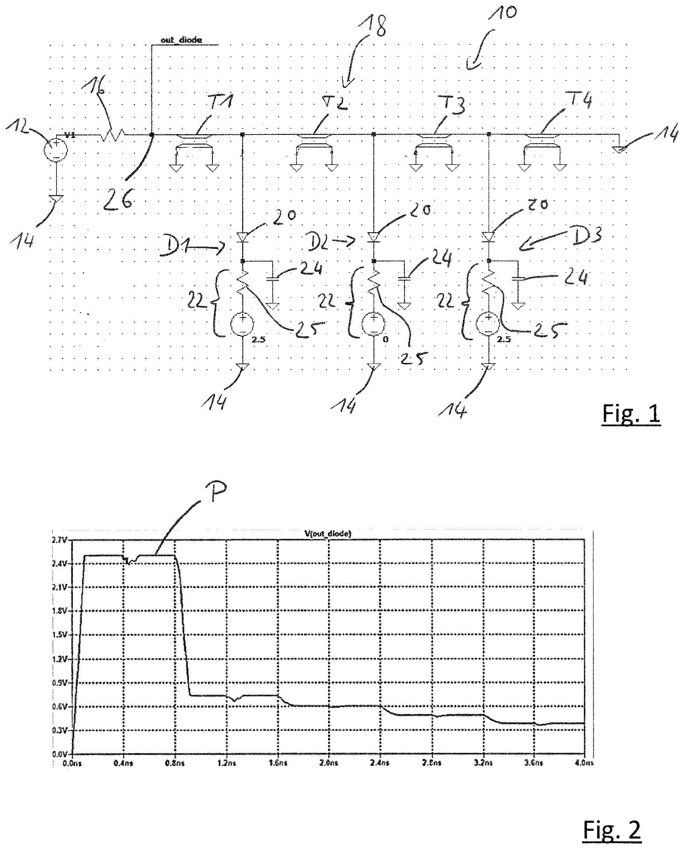

Fig. 1 zeigt eine erste Ausführungsform einer Pulserzeugungsvorrichtung 10. Die Pulserzeugungsvorrichtung 10 umfasst eine als Spannungsquelle ausgebildete Signalquelle 12. Die Signalquelle 12 ist zum einen mit einem Massepotential 14 und zum anderen mit einem Anpasswiderstand 16 gekoppelt. Über den Anpasswiderstand 16 ist die Signalquelle 12 zudem mit einem Verzögerungsglied 18 verbunden, welches vier Teil-Verzögerungsglieder, nämlich ein erstes Teil-Verzögerungsglied T1, ein zweites Teil-Verzögerungsglied T2, ein drittes Teil-Verzögerungsglied T3 und ein viertes Teil-Verzögerungsglied T4 umfasst. Das vierte Teil-Verzögerungsglied ist wiederum mit dem Massepotential 14 gekoppelt. Die Teil-Verzögerungsglieder T1, T2, T3 und T4 sind zwischen den Anpasswiderstand 16 und das Massepotential 14 in Reihe geschaltet.

Die jeweils der Signalquelle 12 zugewandte Seite bzw. der der Signalquelle 12 zugewandte Anschluss der Teil-Verzögerungsglieder T1, T2, T3, T4 wird auch als Eingang der Teil-Verzögerungsglieder bezeichnet. Der jeweils andere Anschluss der Teil-Verzögerungsglieder T1, T2, T3, T4 ist dementsprechend ein Ausgang.

Die Verbindung zwischen dem Anpasswiderstand 16 und dem Eingang des ersten Teil-Verzögerungsglieds T1 bildet einen Signalausgang 26, an welchem das Signal "out_diode" ausgegeben wird.

An einer Verbindung zwischen dem ersten Teil-Verzögerungsglied T1 und dem zweiten Teil-Verzögerungsglied T2 ist ein erster Diodenschalter D1 angeschlossen. In entsprechender Weise ist ein zweiter Diodenschalter D2 an einer Verbindung zwischen dem zweiten Teil-Verzögerungsglied T2 und dem dritten Teil-Verzögerungsglied T3 und ein dritter Diodenschalter D3 an einer Verbindung eines dritten Teil-Verzögerungsglieds T3 und eines vierten Teil-Verzögerungsglieds T4 angeschlossen.

Bei jedem der Diodenschalter D1, D2, D3 ist eine Diode 20 vorgesehen, deren Anode mit dem jeweiligen Teil-Verzögerungsglied T1 bis T4 gekoppelt ist. Die Kathode der Diode 20 ist jeweils mit einer Parallelschaltung einer Steuer-Spannungsquelle 22 und einer Stützkapazität 24 verbunden. Ein Innenwiderstand 25 der Steuer-Spannungsquelle 22 ist jeweils explizit dargestellt und kann beispielsweise 10 kΩ betragen. Die Steuer-Spannungsquelle 22 und die Stützkapazität 24 sind zudem mit Massepotential 14 gekoppelt.

Zum Erzeugen eines Pulses wird von der Signalquelle 12 ein Eingangssignal von 5 V ausgegeben, welches als Spannungswelle zunächst den Anpasswiderstand 16 durchläuft. Die Spannungswelle durchläuft weiterhin das erste Teil-Verzögerungsglied T1, wodurch sich am Signalausgang 26 aufgrund des Spannungsteilers von Anpasswiderstand 16 und erstem Teil-Verzögerungsglied T1 eine Spannung von 2,5 V einstellt, da die Teil-Verzögerungsglieder T1-T4 und der Anpasswiderstand 16 alle einen Widerstand bzw. Wellenwiderstand von 50 Ω besitzen.

An der Anode der Diode 20 des ersten Diodenschalters D1 liegt somit eine Spannung von 2,5 V an. Diese Spannung entspricht aber genau der Spannung an der Kathode der Diode 20 des ersten Diodenschalters D1, wodurch die Diode des ersten Diodenschalters D1 sperrt. Das Eingangssignal durchläuft nachfolgend das zweite Teil-Verzögerungsglied T2 und liegt dann an der Anode der Diode 20 des zweiten Diodenschalters D2 an. Dort liegt an der Kathode aber 0 V an, so dass die Diode 20 leitend wird. Aufgrund der auch hochfrequenten Natur des Eingangssignals ist die Stützkapazität 24 niederimpedant, wodurch die Stützkapazität für das Eingangssignal eine Verbindung nach Massepotential 14 herstellt.

Die Spannungswelle des Eingangssignals durchläuft somit die Diode 20 des zweiten Diodenschalters. Daraufhin wird die Spannungswelle an Massepotential 14 wie an einem Kurzschluss negativ reflektiert und läuft durch das zweite Teil-Verzögerungsglied T2 und das erste Teil-Verzögerungsglied T1 zurück zum Signalausgang 26, wo sie das bisherige Eingangssignal auslöscht, so dass die Spannung am Signalausgang auf Null absinkt. In diesem Beispiel bewirkt jedes Teil-Verzögerungsglied T1-T4 eine Verzögerung von 200 ps. Es werden zwei Teil-Verzögerungsglieder jeweils zwei Mal durchlaufen, so dass sich ein Puls P mit einer Länge von 800 ps (0,8 ns) ergibt.

Der beim Betrieb der Pulserzeugungsvorrichtung 10 von Fig. 2 am Signalausgang 26 entstehende elektrische Puls P ist in Fig. 2 gezeigt. In Fig. 2 ist zu erkennen, dass mit dem Einschalten der Signalquelle 12 ein schneller Anstieg der Spannung am Signalausgang 26 erfolgt. Nach etwa 0,8 ns endet der Puls P und die Spannung fällt zunächst auf 0,7 V zurück, wobei die Spannung dann treppenförmig noch weiter fällt. Es ist zu erkennen, dass während des Pulses P ein kurzer minimaler Einbruch der Spannung bei etwa 0,4 ns erfolgt. Vergleichssimulationen haben ergeben, dass bei einem Einsatz von Bipolartransistoren aufgrund der hohen Kollektor-Basis-Kapazität von z.B. 1 pF ein deutlich höherer Einbruch während des Pulses erfolgen würde, der keine verlässliche Funktion der Pulserzeugungsvorrichtung zulässt. Der Einsatz der Diodenschalter D1-D3 bietet also deutliche Vorteile.

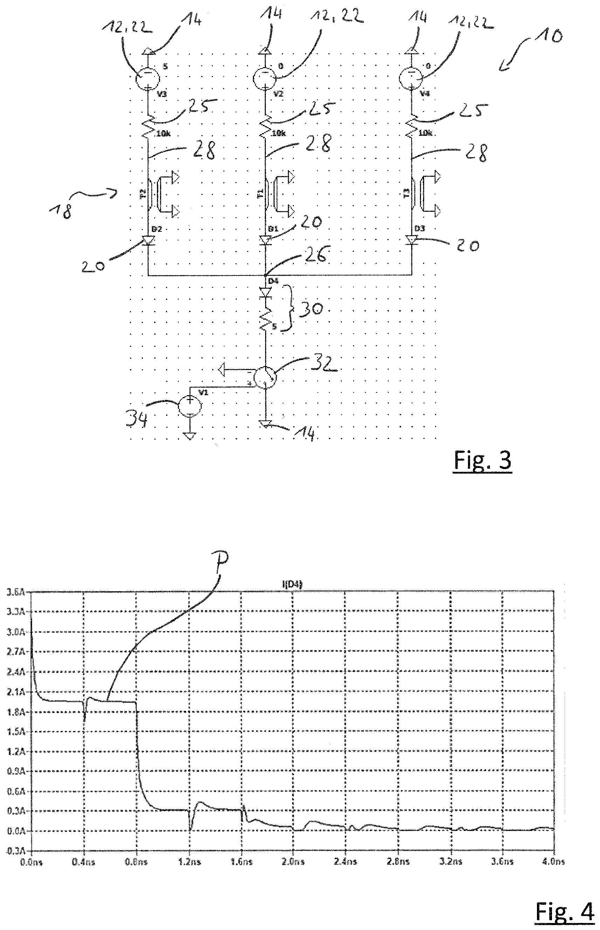

In der zweiten Ausführungsform gemäß Fig. 3 sind drei Teil-Verzögerungsglieder T1-T3 vorhanden, die in drei Strängen 28 angeordnet und parallel zueinander geschaltet sind. Jeder Strang 28 umfasst eine Reihenschaltung von Steuer-Spannungsquelle 22 (mit ihrem Innenwiderstand 25), Teil-Verzögerungsglied T1, T2, T3 und Diode 20. Die Stränge 28 sind am Signalausgang 26 miteinander verbunden, wobei die Dioden 20 jeweils mit ihrer Kathode mit dem Signalausgang 26 gekoppelt sind. Die anderen Enden der Stränge 28 sind mit Massepotential 14 verbunden. Der Innenwiderstand 25 kann auch einen als separates Widerstandsbauteil ausgebildeten Widerstand umfassen.

Am Signalausgang 26 ist zudem eine Laserdiode 30 angeschlossen. Der Innenwiderstand der Laserdiode 30 ist in Fig. 3 ebenfalls dargestellt. Die Laserdiode 30 ist wiederum mit einem Auslöseschalter 32 verbunden, der durch eine Auslösequelle 34 gesteuert wird. Durch den Auslöseschalter 32 kann die Laserdiode 30 mit Massepotential 14 verbunden werden. Der Auslöseschalter 32 kann beispielsweise ein Bipolar- oder ein Feldeffekttransistor sein.

In Fig. 3 ist die Steuer-Spannungsquelle 22 des zweiten Strangs 28 eingeschaltet und liefert 5V. Die anderen Steuer-Spannungsquellen 22 sind deaktiviert (0V).

Durch die aktive Steuer-Spannungsquelle 22 des ersten Strangs 28 wird an dem Signalausgang 26 zunächst eine Spannung von ebenfalls 5V angelegt. Die anderen Stränge sind elektrisch durch die Dioden von dem Signalausgang getrennt.

Der Auslöseschalter 32 ist zunächst nicht-leitend geschaltet, so dass durch die Laserdiode 30 kein Strom fließt. Wird der Auslöseschalter 32 nun durch aktivieren der Auslösequelle 34 leitend geschaltet, so wird die Laserdiode 30 über den Auslöseschalter 32 mit Massepotential 14 verbunden. Dadurch beginnt ein Stromfluss im Signalausgang 26, d.h. ein Puls 26 beginnt.

Durch den Stromfluss stellt sich ein Spannungsteiler zwischen der Laserdiode 30 und dem zweiten Teil-Verzögerungsglied T2 ein. Durch die am Signalausgang 26 plötzlich erniedrigte Spannung entsteht eine Stromwelle, welche die Diode 20 und das Teil-Verzögerungsglied T2 des zweiten Strangs 28 durchläuft, an dem Innenwiderstand 25 der Steuer-Spannungsquelle 22 des ersten Strangs 28 mit negativer Phase reflektiert wird und zum Signalausgang 26 zurückkehrt, wo der Stromfluss durch die reflektierte Welle strommäßig ausgelöscht wird. Damit endet der Stromfluss durch die Leucht- oder Laserdiode nach sehr kurzer Zeit, wodurch ein Puls P entsteht (Fig. 4). Die Zeitdauer des elektrischen Pulses entspricht insbesondere der doppelten Durchlaufdauer durch das erste Teil-Verzögerungsglied T2.

Der Signalverlauf am Signalausgang 26, welcher beim Betrieb der Pulserzeugungsvorrichtung 10 gemäß Fig. 3 entsteht, ist in Fig. 4 gezeigt. Fig. 4 zeigt den Strom durch die Laserdiode 30. Der Strom nimmt nach dem Schließen des Auslöseschalters 32 zunächst sprunghaft zu und pendelt sich dann auf ein Plateau ein, so dass sich der Puls P ergibt. Nach dem doppelten Durchlaufen durch das zweiten Teil-Verzögerungsglied T2 nimmt der Strom zunächst stark auf 0,3 A ab und wird dann weiter bis auf 0 reduziert. Durch den kurzen Strompuls gibt die Laserdiode 30 einen kurzen optischen Puls ab, welcher beispielsweise in einem, nicht gezeigten, Laserscanner verwendet werden kann.

### Bezugszeichenliste

- 10: Pulserzeugungsvorrichtung
- 12: Signalquelle
- 14: Massepotential
- 16: Anpasswiderstand
- 18: Verzögerungsglied
- 20: Diode
- 22: Steuer-Spannungsquelle
- 24: Stützkapazität
- 25: Innenwiderstand der Steuer-Spannungsquelle
- 26: Signalausgang
- 28: Strang
- 30: Laserdiode
- 32: Auslöseschalter
- 34: Auslösequelle
- T1 - T4: Teil-Verzögerungsglieder
- D1 - D3: Diodenschalter
- P: Puls

## Patentansprüche

1. Pulserzeugungsvorrichtung (10), ausgebildet zur Erzeugung von elektrischen Pulsen (P) mit Pulsdauern im Bereich von Nanosekunden, bevorzugt mit Spannungen von maximal 60V und/oder Strömen von maximal 20A, mit einer Signalquelle (12), welche ein Eingangssignal bereitstellt,
einem mit der Signalquelle (12) elektrisch gekoppelten Verzögerungsglied (18), welches ein an das Verzögerungsglied (18) angelegtes Signal beim Durchlaufen des Verzögerungsglieds (18) um eine vorbestimmte Zeitdauer verzögert,
ein oder mehreren Reflexionsmitteln (14, 25), welche das Verzögerungsglied (18) durchlaufende Signale reflektieren, und
einem Signalausgang (26) zur Ausgabe der elektrischen Pulse (P), welcher elektrisch mit dem Verzögerungsglied (18) verbunden ist,
**dadurch gekennzeichnet, dass**
das Verzögerungsglied (18) mehrere Teil-Verzögerungsglieder (T1-T4) und die Pulserzeugungsvorrichtung (10) einen oder mehrere Diodenschalter (D1-D3) aufweisen, wobei jeder Diodenschalter (D1-D3) mit zumindest einem Teil-Verzögerungsglied (T1-T4) elektrisch verbunden ist,
wobei jeder Diodenschalter (D1-D3) eine Diode (20) und eine der Diode (20) zugeordnete Steuer-Spannungsquelle (22) umfasst, wobei durch Veränderung der Spannung der Steuer-Spannungsquelle (22) das jeweilige Teil-Verzögerungsglied (T1-T4) wahlweise mit zumindest einem der Reflexionsmittel (14, 25) elektrisch verbindbar ist.

2. Pulserzeugungsvorrichtung (10) nach Anspruch 1,
wobei die Diode (20) und die Steuer-Spannungsquelle (22) zumindest eines Diodenschalters (D1-D3) in Reihe geschaltet sind.

3. Pulserzeugungsvorrichtung (10) nach Anspruch 1 oder 2,
wobei die Teil-Verzögerungsglieder (T1-T4) ein Signal beim Durchlaufen um dieselbe vorbestimmte Zeitdauer verzögern
oder
wobei zumindest zwei der Teil-Verzögerungsglieder (T1-T4) ein Signal beim Durchlaufen um unterschiedliche vorbestimmte Zeitdauer verzögern.

4. Pulserzeugungsvorrichtung (10) nach einem der vorstehenden Ansprüche, wobei zumindest ein Diodenschalter (D1-D3) ausgebildet ist, durch eine elektrische Verbindung eines Teil-Verzögerungsglieds (T1-T4) mit einem der Reflexionsmittel (14, 25), ein Durchlaufen des Eingangssignals durch das Teil-Verzögerungsglied (T1-T4) zu bewirken.

5. Pulserzeugungsvorrichtung (10) nach einem der vorstehenden Ansprüche, wobei zumindest ein Diodenschalter (D1-D3) ausgebildet ist, im leitenden Zustand von dem Eingangssignal durchlaufen zu werden, wobei das Eingangssignal bevorzugt durch die Diode (20) und/oder auch durch die Steuer-Spannungsquelle desjenigen Diodenschalters (D1-D3) durchläuft.

6. Pulserzeugungsvorrichtung (10) nach einem der vorstehenden Ansprüche, wobei die Diode (20) zumindest eines Diodenschalters (D1-D3) eine pn-Diode, insbesondere eine Schottky-Diode ist.

7. Pulserzeugungsvorrichtung (10) nach einem der vorstehenden Ansprüche, wobei die Diode (20) zumindest eines Diodenschalters (D1-D3) eine Kapazität von weniger als 400 fF, bevorzugt von weniger als 300 fF oder 200 fF, aufweist.

8. Pulserzeugungsvorrichtung (10) nach einem der vorstehenden Ansprüche, wobei ein Anpasselement (16) vorhanden ist, welches eine Anpassung des Widerstands der Signalquelle (12) an den Wellenwiderstand des Verzögerungslieds bewirkt.

9. Pulserzeugungsvorrichtung (10) nach einem der vorstehenden Ansprüche, wobei das Anpasselement (16) eine nicht-leuchtende Diode und/oder eine Leuchtdiode und/oder eine Laserdiode (30) und bevorzugt einen ohmschen Widerstand umfasst, wobei die Größe des ohmschen Widerstands kleiner als der Wellenwiderstand oder gleich dem Wellenwiderstand des Verzögerungsglieds (18) ist.

10. Pulserzeugungsvorrichtung (10) nach einem der vorstehenden Ansprüche, wobei der Signalausgang (26) mit einem Pegelwandler gekoppelt ist, insbesondere mit einem Logikgatter.

11. Pulserzeugungsvorrichtung (10) nach einem der vorstehenden Ansprüche, wobei die Signalquelle (12) und die Teil-Verzögerungsglieder (T1-T4) in Reihe geschalten sind, wobei einer der Diodenschalter (D1-D3) jeweils an einer elektrischen Verbindung zwischen zwei Teil-Verzögerungsgliedern (T1-T4) angeschlossen ist.

12. Pulserzeugungsvorrichtung (10) nach zumindest einem der Ansprüche 1 bis 10,
wobei die Pulserzeugungsvorrichtung (10) mehrere Stränge (28) aus jeweils einer der Dioden (20), einem der Teil-Verzögerungsglieder (T1-T4) und einer der Steuer-Spannungsquellen (22) umfasst, wobei die mehreren Stränge (28) zueinander parallel geschalten sind.

13. Pulserzeugungsvorrichtung (10) nach einem der vorstehenden Ansprüche, wobei zumindest eine der Steuer-Spannungsquellen (22) zugleich auch als Signalquelle (12) und/oder zugleich auch als Reflexionsmittel (14, 25) dient.

14. Entfernungsmessendes optoelektronisches System, beispielsweise Laserscanner, mit einer Pulserzeugungsvorrichtung (10) nach zumindest einem der Ansprüche 1 bis 13 und mit zumindest einer Laserquelle (30), welche mit von der Pulserzeugungsvorrichtung (10) erzeugten Pulsen (P) betrieben wird.

15. Verfahren zur Erzeugung von elektrischen Pulsen (P) mit Pulsdauern im Bereich von Nanosekunden, bevorzugt mit Spannungen von maximal 60V und/oder Strömen von maximal 20A, bei welchem
- eine Signalquelle (12) ein Eingangssignal erzeugt,
- das Eingangssignal ein Verzögerungsglied (18), welches ein an das Verzögerungsglied (18) angelegtes Signal beim Durchlaufen des Verzögerungsglieds (18) um eine vorbestimmte Zeitdauer verzögert, durchläuft,
- das Eingangssignal nach dem Durchlaufen zumindest eines Teils des Verzögerungsglieds (18) an ein oder mehreren Reflexionsmitteln (14, 25) reflektiert wird,
- eine Überlagerung des Eingangssignals und des reflektierten Eingangssignals erfolgt, um einen elektrischen Puls (P) zu erzeugen,
**dadurch gekennzeichnet, dass**
das Verzögerungsglied (18) mehrere Teil-Verzögerungsglieder (T1-T4) und die Pulserzeugungsvorrichtung (10) einen oder mehrere Diodenschalter (D1-D3) aufweisen, wobei jeder Diodenschalter (D1-D3) mit zumindest einem Teil-Verzögerungsglied (T1-T4) elektrisch verbunden ist, wobei jeder Diodenschalter (D1-D3) eine Diode (20) und eine der Diode (20) zugeordnete Steuer-Spannungsquelle umfasst, wobei die Spannung zumindest einer der Steuer-Spannungsquellen verändert wird, um ein Teil-Verzögerungsglied (T1-T4) mit zumindest einem der Reflexionsmittel (14, 25) elektrisch zu verbinden oder elektrisch von dem Reflexionsmittel (14, 25) zu trennen.
